Europäisches Patentamt

European Patent Office

Office européen des brevets

(19)

(11) Publication number: **0 192 871**
**B1**

(12) **EUROPEAN PATENT SPECIFICATION**

(45) Date of publication of patent specification: **07.02.90**

(51) Int. Cl.⁵: **H 01 L 21/90, H 01 L 21/31**

(21) Application number: **85305819.6**

(22) Date of filing: **15.08.85**

(54) A method of forming a polysilicon resistor in a polycide line.

(30) Priority: **31.01.85 US 696918**

(43) Date of publication of application:
**03.09.86 Bulletin 86/36**

(45) Publication of the grant of the patent:
**07.02.90 Bulletin 90/06**

(84) Designated Contracting States:
**DE FR GB NL**

(56) References cited:
**EP-A-0 078 190**
**US-A-4 136 434**
**US-A-4 400 867**

(73) Proprietor: **THORN EMI North America Inc.**
**P.O. Box 16000**
**Colorado Springs Colorado 80935 (US)**

(72) Inventor: **Bourassa, Ronald R.**
**544 Anaconda Drive**
**Colorado Springs Colorado 80919 (US)**

(74) Representative: **Palmer, Roger et al**
**PAGE, WHITE & FARRER 54 Doughty Street**
**London WC1N 2LS (GB)**

Courier Press, Leamington Spa, England.

## Description

The present invention relates to methods of forming polysilicon resistors in a polycide line. "Polycide" is a term known in the semiconductor fabrication art for a multi-layered structure having a layer of silicide, such as titanium silicide or tungsten silicide, on top of a layer of polysilicon.

Polysilicon can have a low resistance or a high resistance or resistivity, depending on how it is doped, and in current semiconductor technology, resistors are often fabricated in a polysilicon layer. The resistor can be in a word line or other line which has other parts which should be highly conductive. Thus, polycide, which can be very conductive, is used for lines in semiconductor devices as memories. The resistor can be formed in the polysilicon part of the polycide.

If the polycide is formed to consist simply of polysilicon covered with a silicide, and then the silicide is selectively etched to expose areas which are to be resistors, it has been found that the resistors formed are not uniform. Indeed, there are some resultant resistors which can fairly be called freaks. It would appear that there is some interaction between the silicide and the polysilicon which produces an adverse effect.

EP—A—0078190 discloses a method of forming a polysilicon resistor in which resin plugs are formed on a polysilicon layer in regions where resistors are to be formed. The resin plugs form a temporary barrier while doping is effected and a silicide layer deposited but the resin plugs are removed prior to completion of the device.

It is an object of the present invention to provide an improved method wherein a permanent barrier is formed between the resistor region of the polysilicon and the silicide layer.

The present invention provides a method of forming a polysilicon resistor in a polycide line including designating a polysilicon region to include the resistor, doping the polysilicon while protecting said region with a barrier material, adding a silicide layer thereover and defining the silicide, establishing an opening in a layer over the polysilicon to expose the polysilicon region where the polysilicon resistor is to be located, then permanently locating a barrier material on top of said polysilicon substantially within said opening, then adding a silicide layer over the polysilicon and the barrier material, and defining said layer and barrier to form a polysilicon resistor in contact with a polycide line, the resistor being separated from the silicide by the defined barrier material.

In an embodiment, a mask is used to implant an impurity into a selected region of the polysilicon. The selected region is preferably larger than the resistor to be formed. The doping is relatively light, as is usual for a polysilicon resistor.

Then a dielectric material is established over the selected region. Preferably this is achieved by oxidizing the selected region, preferably using nitride over other areas so that the oxidation is selective. This oxidation reduces the thickness of the lightly doped polysilicon in the region where the resistor is being formed. Areas outside the resistor region will generally not be thinned by the oxidation step.

Next, the entire area may be heavily doped to lower the resistivity of the polysilicon. However, the grown oxide shields the resistor area from this doping. Then the silicide and the polysilicon are etched, preferably in two steps, to define the conductive polycide line. Preferably, the silicide over the selected resistive region is removed substantially entirely. The grown oxide in the resistive region acts as an etch stop. Then the resistor area is defined.

The method of the invention has the advantage that the lightly doped polysilicon will etch slower than the heavily doped polysilicon. In one embodiment, this fact is used in that lightly doped or undoped parts of the polysilicon are made thinner by selective oxidation. The etching completion time will then be about equal for the thicker doped or undoped polysilicon. This prevents underlying oxide from being appreciably etched. If the underlying oxide were gate oxide, appreciable etching thereof would cause serious problems.

Embodiments of the present invention will hereinafter be described, by way of example, with reference to the accompanying drawings, in which:

Figure 1 illustrates an intermediate structure developed in the early stages of a process according to a first embodiment of the present invention, and illustrates in cross-section a substrate having a layer of polysilicon and layers of thin oxide and nitride thereon;

Figure 2 shows a plan view of a mask for a resistive area which encompasses a designated resistor region;

Figure 3 is a cross-section taken along the line A—A of Figure 2 after etching to show the implantation of boron into what will become a resistive region in the polysilicon;

Figure 4 illustrates the structure of Figure 3 after the photoresist has been removed and oxide has been grown onto the broad area encompassing the designated resistor regions;

Figure 5 illustrates the structure of Figure 4 after the nitride and thin oxide have been removed and a layer of silicide has been added;

Figure 6 shows a plan of a definition mask for a polycide line;

Figure 7 shows a cross-section of the resistive region taken along the line B—B of Figure 6 after the silicide and polysilicon have been etched, leaving the doped polysilicon region covered by relatively thick oxide;

Figure 8 shows a section taken along the line C—C of Figure 6 after etching;

Figure 9 illustrates in plan view the application of a separate resistor definition mask over the resistive regions of polysilicon covered with oxide;

Figure 10 shows a cross-section taken along the line D—D of Figure 9 after etching;

Figure 11 shows a cross-section taken along the line E—E of Figure 9 and showing a longitudinal section of a polycide line with a polysilicon resistor therein;

Figure 12 shows a plan view of an alternative embodiment of a mask for defining both the polycide line and the polysilicon resistor;

Figure 13 shows a section taken along the line F—F of Figure 12 and showing photoresist on top of a silicide layer;

Figure 14 is a section taken along the line G—G of Figure 12 after etching;

Figure 15 is a further sectional view taken along the line F—F of Figure 12 to show the structure of the polysilicon resistor covered by silicide after etching;

Figure 16 illustrates the next step in the alternative embodiment of the present invention showing an oxide which has been grown or deposited to protect the side walls of the polysilicon resistor;

Figure 17 is another section showing the structure of Figure 16 after one type of etching which leaves oxide on top of the polysilicon resistor; and

Figure 18 is another view of the structure of Figure 16 after etching to remove both the oxide, the underlying silicide, and a relatively thick oxide.

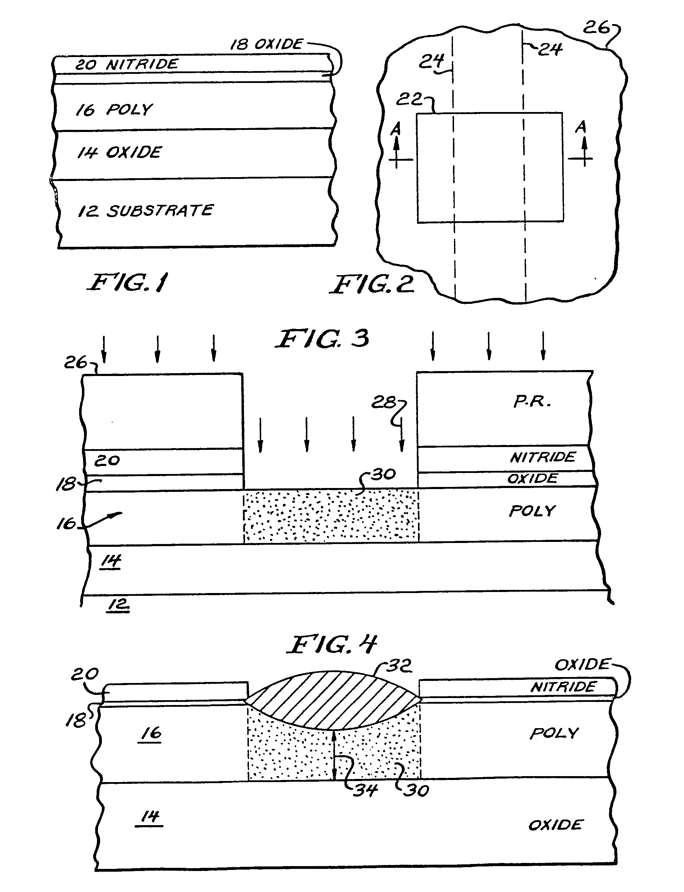

Figures 1 to 11 of the accompanying drawings together illustrate a first embodiment of a process of the invention for fabricating a polysilicon resistor in a polycide line. As is shown in Figure 1, initially a layer of gate oxide or field oxide 14 is established on a single crystal silicon substrate 12. Generally, the oxide layer 14 will have a thickness of about 600 nm (6000 angstroms). Then a layer 16 of polycrystalline silicon is deposited onto the oxide layer 14. This polysilicon layer 16 will be substantially of the order of 600 nm (6,000 angstroms) thick. Following this, a thin layer 18 of oxide, about 45 nm (450 angstroms) thick is deposited and then a layer 20 of nitride, about 100 nm (1,000 angstroms) thick is established. The nitride layer 20 is used because of its oxidation inhibiting properties, and alternative materials having such properties could be used in place of the nitride layer.

Figure 2 shows a plan view of a photoresist mask which is placed on top of the nitride layer 20 and which defines a rectangular area 22 within which polysilicon resistors are to be formed. Dotted lines 24 are shown in Figure 2 and represent the approximate borders of what will become a polycide line outside of the area 22 and a polysilicon resistor within the area 22.

Thus, within the rectangular area 22, the dotted lines 24 delineate a designated resistor region. In a semiconductor static RAM, for example, two or more polysilicon resistors would normally be formed within the area 22. For ease of explanation and illustration, only one polycide line and its resistor is illustrated and described, it being understood that two or more such resistors can be formed within the rectangular area 22 by a process of the invention.

The photoresist mask placed on top of the nitride layer 20 to mask all areas thereof except for the rectangular area 22 preferably has a thickness of about 10,000 angstroms. The masked structure is then etched such that the nitride layer 20 and then the underlying oxide layer 18 within the area 22 are etched away to expose part of the polysilicon layer 16. Thereafter a dopant is implanted into the polysilicon exposed within the area 22 for what will later become a resistor. The concentration and dose of the dopant may be of the values customarily used for fabricating resistors. If it is desired to form a conventional polysilicon resistor as generally used in the art, the dopant would be phosphorous or arsenic.

Alternatively, the dopant could be boron alone or boron together with either phosphorous or arsenic. For example, EP—A—0112097 (Application No. 83307323.2) describes back to back boron diodes or nearly compensated diodes which can be used as resistors. In the following description the dopant is boron but this is solely by way of illustration.

The boron does not appreciably enter any parts of the polysilicon layer 16 other than those within the rectangular area 22 because those other parts are protected by the layer of photoresist, by the nitride layer 20 and by the thin oxide layer 18. The doping step is illustrated in Figure 3 which shows a cross-section taken along the line A—A of Figure 2. Figure 3 shows the photoresist 26, and arrows 28 indicate the boron implant into what becomes a lightly doped resistive region 30 of the polysilicon layer 16 within the rectangular area 22.

The photoresist 26 is removed after the doping step, but the nitride layer 20 is left in place outside the rectangular area 22. Then a thick oxide 32 is grown onto the exposed region 30 of the polysilicon layer 16 as is shown in Figure 4. The nitride layer 20 prevents the oxide from growing anywhere except within the rectangular area 22. The oxide 32 is about 350 nm (3,500 angstroms) thick and grows into the region 30 such that the depth of the region 30 of the polysilicon layer 16 is reduced. Arrow 34 shows the thickness of the polysilicon layer remaining within the area 22 after the thick oxide 32 has been grown. Initially, the polysilicon layer 16 was 600 nm (6,000 angstroms) thick, but after this oxidation step its depth within the area 22 at the arrow 34 will only be of the order of 400 to 500 nm (4,000 to 5,000 angstroms). Note also that as the oxide layer 32 has a thickness of about 350 nm (3,500 angstroms) it projects above the surface of the layer 16. Of course, the thickness of the polysilicon layer 16 outside the rectangular area 22 remains at about 600 nm (6,000 angstroms).

The nitride layer 20 and the underlying thin oxide layer 18 are then removed, and the structure (a polysilicon layer with a relatively thick oxide 32 thereon at rectangle 22), is subjected to heavy doping, if desired, in a furnace. The dopant can be arsenic or phosphorous although arsenic is preferred. The resultant structure thus has a boron doped resistive polysilicon region 30 covered with a thick grown oxide 32 and surrounded by polysilicon doped to be as conductive as is required. Any minor amounts of oxide which have formed during the doping cycle are removed from the structure reducing its thickness by about 500 angstroms.

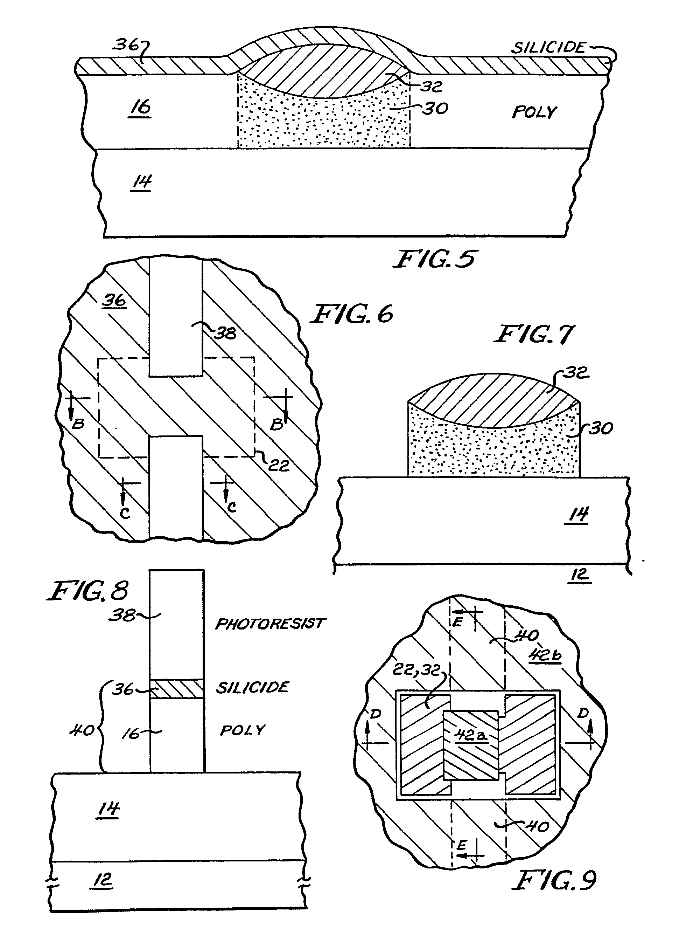

As illustrated in Figure 5, a layer 36 of silicide is then deposited over the entire structure. Preferably, the silicide layer 36 has a thickness of the order of 200 to 300 nm (2,000 to 3,000 angstroms). Figure 5 shows a section taken along the line A—A of Figure 2 through the area 22. Of course, the silicide covers both the rectangular area 22 which defines the resistive region and the other parts of the structure.

Next a definition mask 38 of photoresist is placed on the structure. A plan view of the mask 38 is shown in Figure 6 and it will be seen that the mask is open over the area 22 but that it covers the areas to be the polysilicon or polycide line. In Figure 6, the area 22 is covered by the silicide layer 36 and is therefore shown in dashed lines. The photoresist mask 38 lies on top of the silicide layer.

The silicide layer 36 and the underlying polysilicon layer 16 are then etched using conventional etching processes. The thick oxide layer 32 coextensive with and defined by the rectangular area 22 acts as an etch stop so that the resistive region 30 will not be etched. Figure 7 shows a section through the resistive region taken along the line B—B of Figure 6 after the silicide and poly etch. Figure 8 is a section through the polycide line taken along the line C—C of Figure 6 after the etching process. As can be seen, this etching step forms a polycide line 40 having an upper silicide portion 36 which is about 250 nm (2,500 angstroms) thick over a nominally 550 nm (5,500 angstrom) thick polysilicon portion 16 which will have been doped for conductivity in previous steps. The polycide line 40 is interrupted by the resistive region 30 of the polysilicon within the area 22 which is covered by the thick oxide layer 32. The silicide 36 which had overlain the rectangular area 22 has been etched away except under parts of the mask 38 which project slightly over the area 22.

The photoresist 38 is then removed and an oxide (not shown) is grown or deposited to cover the top and sides of the polycide lines 40. Where the polycide lines are used as gate electrodes, this oxide ensures that subsequent source and drain implants will be initially offset relative to the gate electrode but that heat driving will align the source and drain regions with substantially zero overlap. The thick oxide layer 32 protects the resistive region 30 of the polysilicon from arsenic implants for the source and drain regions.

The next step is to define the polysilicon resistor itself within the rectangular area 22. This is done by adding a photoresist mask 42 over the area 22 as is shown in Figure 9. The mask 42 in this embodiment has two portions, a first portion 42a within the area 22 and a second portion 42b outside the area 22. The first portion 42a is laid on top of the thick oxide 32 and is intended to be aligned with the polycide lines 40. However, and as shown in Figure 9, the first portion 42a of the mask may be partially misaligned with respect to the polycide lines 40. This is to illustrate the normal tolerance in the fabrication equipment. The second portion 42b of the photoresist mask outside of the area 22 covers the polycide lines 40 as represented in broken lines.

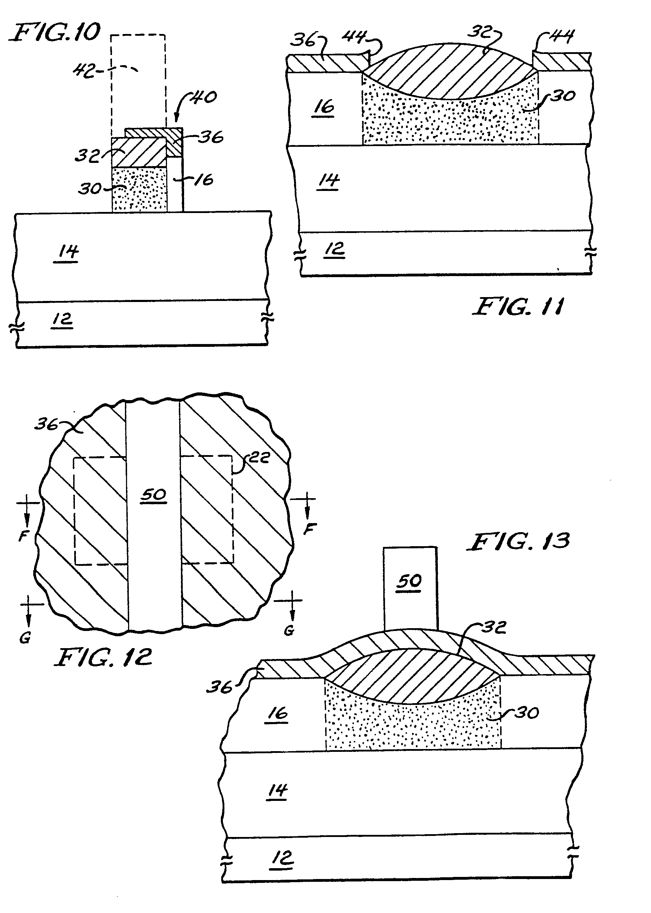

The oxide layer 32 and the underlying boron-doped polysilicon region 30 are then etched away except for the area thereof the first photoresist portion 42a to form a polycide line 40 containing a resistor in the polysilicon, the resistor being covered with the thick oxide layer 32. Figures 10 and 11 illustrate the resultant structure after etching being, respectively, sections along the lines D—D and E—E of Figure 9. In Figure 10 the location where the photoresist 42 had been located is shown in dashed lines. As can be seen, it is slightly displaced to the left of the polycide line 40. Note that the heavily doped polysilicon 16 is thicker than the lightly doped polysilicon 30. The etching is a two-step process by means of which first the oxide and then the poly are etched using different etchants in customary well-known fashion.

Figure 11 shows a section along the polycide line. The central portion of Figure 11 shows the remaining thick oxide layer 32 covering the boron-doped resistive region 30 which has now been defined into a resistor. Outside of the resistive region 30 are more heavily doped, thicker conductive regions of the polysilicon layer 16. These conductive regions are covered by the silicide 36. As can be seen, the silicide extends partially over the thick oxide 32, and this is because the photoresist mask 38 partially extended into and overlapped the rectangular area 22 as shown in Figures 6 and 9. The innermost edges 44 of the silicide curve upwardly to conform with the bottom edge which rises on account of oxide 32 (see Figure 5).

The embodiment described has the advantage that one photolithography step is used for the resistor implant, the poly doping and the source-drain implants. This saves one mask in NMOS where there normally are separate poly doping and implant masks.

By not cutting the actual resistor line until after the source-drain implant, there is no concern that the side wall of the resistor might be shorted in the source-drain implantation. In other words, the source-drain implantation even at the usual 7° angle is unlikely to penetrate the side walls of the rectangular area 22 so that it would reach the area under photoresistor 42. Thus, resistive characteristics are preserved.

Another advantage of this process is that the silicide 36 which is deposited over the polysilicon is never the contact with the specific polysilicon which forms the resistors. This is because a thick oxide 32 separates the silicide from the polysilicon as is clear from Figure 5. Thus there is no opportunity for the resistive region to be adversely affected by interacting with the silicide.

As explained above, another advantage is that the completion time for etching the heavily doped poly is about the same as the completion time for etching the lightly doped poly.

The first embodiment of a process of the invention which is described above is summarized by the following steps:

1. Deposit a polysilicon layer on a substrate.
2. Develop a thin oxide layer and deposit a nitride layer thereover (Figure 1).
3. Designate by a photoresist a resistor area and etch through the nitride and the thin oxide layers to expose the polysilicon in said designated area.
4. Selectively dope the exposed polysilicon (Figures 2 and 3).
5. Remove the photoresist.
6. Grow thick oxide over the polysilicon in said designated area (Figure 4).
7. Remove the nitride and the thin oxide layers.
8. Selectively dope the polysilicon outside the designated area to make it conductive except where the thick oxide masks it.
9. Remove any oxide caused by the doping process.
10. Deposit a silicide layer over the exposed polysilicon and the thick oxide (Figure 5).
11. Add a mask defining polycide lines and leaving the designated area open (Figure 6).
12. Etch the silicide and polysilicon using the thick oxide on the designated area as an etch stop to form polycide lines adjacent the designated area (Figure 7, 8).
13. Remove the mask.
14. Grow or deposit oxide for zero drain overlap process elsewhere in device.
15. Implant source and drain impurities using the thick oxide over the designated area as a mask.
16. Add a resistor definition mask (Figure 9).
17. Etch the thick oxide and the underlying polysilicon to define a resistor between polycide lines (Figures 10 and 11).

In an alternative embodiment of a process of the invention a structure as shown in Figure 5 is formed as described above with reference to Figures 1 to 5. Briefly the structure has a silicide layer 36 converting both a polysilicon layer 16 and a designated area 22 encompassing a boron doped polysilicon region 30 covered by a thick oxide layer 32. In this alternative embodiment, the resistor is aligned with the polycide lines because both the resistor and the polycide lines are defined in one mask. Thus, Figure 12 shows in plan view a polydefinition mask 50 comprising photoresist which is laid on top of the silicide layer 36. The photoresist 50 crosses over the designated area 22 in which the thick oxide 32 has been grown but which is not visible in Figure 12 because of the layer of silicide 36 on top of it. The oxide layer 32 is shown, however, in Figure 13 which is a section through the resistive polysilicon region 30 taken along the line F—F of Figure 12.

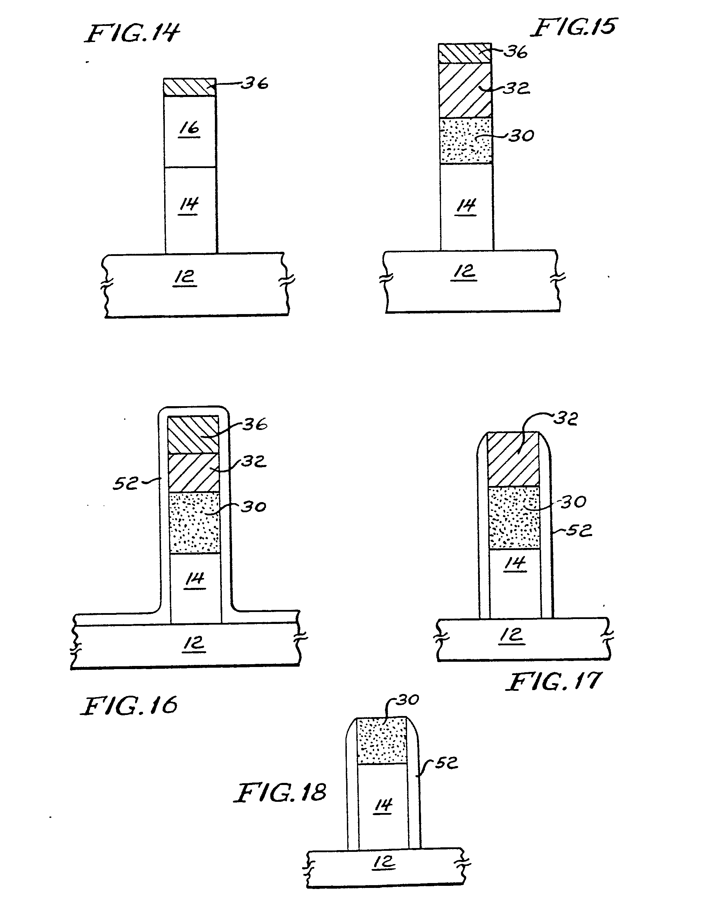

The silicide layer 36 and then the oxide 32 are etched to form the poly lines shown in cross-section in Figures 14 and 15 (the photoresist 50 having been removed). Figure 15 shows a section on the line F—F of Figure 12 showing the now-defined polysilicon resistor. It has a boron-doped polysilicon resistive region 30. Above it is thick oxide 32, and above that is the silicide 36. Figure 14 is a section on the line G—G of Figure 12 and shows the polycide line outside of the resistor. The polycide line has heavily doped conductive polysilicon 16 covered by silicide 36. It will be noted that the thickness of the polysilicon 16 outside the resistor, i.e., in Figure 14, is greater than the thickness of the boron-doped polysilicon region in the resistor (Figure 15). This is due to the oxidation of the upper part of the polysilicon 16 in the area 22 during the formation of the thick oxide 32. This difference in thickness has the advantage that the times required to etch completely through the resistive, lightly doped polysilicon 30 and through the heavily doped conductive polysilicon 16, are substantially the same.

The next step is to deposit or grow oxide on the sides and top of the polycide line for the source/drain implants. An example of a deposited oxide 52 is shown in Figure 16. It covers the whole polycide line and results in a controlled separation of the source/drain implants from the edges of the gate electrode formed by the polycide line where it crosses active area. In this embodiment, as in the first embodiment, the oxide 52, the silicide 36 and the oxide 32 protect the resistive poly region 30 from the source/drain implants.

Next photoresist is added to cover only the former designated area 22 (or at least the defined polysilicon resistor), and etching is done in known fashion to etch the oxide and then the silicide. The thick oxide 32 is preferably not etched substantially, as shown in Figure 17, although it can be etched off to result in the structure shown sectionally in Figure 18.

An advantage of this alternative embodiment is that the resistor is self-aligned to the polycide line. Also, the oxide 32 need not be quite as thick as in the first embodiment described because the silicide 36 and an outer oxide 52 will protect the resistive region 30 from source/drain implants. A further advantage is that only one photo step is used for the resistor implant, the poly doping, and the source/drain implant. As with the first embodiment, one great advantage of the process is that the silicide never directly contacts the resistive, boron-doped polysilicon which is used to form the resistors.

The steps in this alternative embodiment of the invention comprise steps 1 to 10 of the first embodiment, and then:

11A. Add a poly definition mask of photoresist.
12A. Etch the silicide, the oxide and the polysilicon.
13A. Remove the photoresist.
14A. Establish an oxide layer for zero drain overlap.
15A. Implant source/drain impurities.
16A. Cover the structure with photoresist except over the resistor areas.
17A. Etch the oxide and the silicide.

18A. Etch the thick oxide from the top of resistor (optional step).

## Claims

1. A method of forming a polysilicon resistor in a polycide line including designating a polysilicon region to include the resistor, doping the polysilicon while protecting said region with a barrier material, adding a silicide layer thereover and defining the silicide, characterised by establishing an opening in a layer over the polysilicon to expose the polysilicon region where the polysilicon resistor is to be located, then permanently locating a barrier material on top of said polysilicon substantially within said opening, then adding a silicide layer over the polysilicon and the barrier material, and defining said layer and barrier to form a polysilicon resistor in contact with a polycide line, the resistor being separated from the silicide by the defined barrier material.

2. The method of claim 1, wherein said designated polysilicon region is first doped with impurities for a polysilicon resistor and thereafter, the doped region is permanently covered with said barrier material.

3. The method of any of the preceding claims, wherein said barrier material comprises an oxide developed on top of said designated polysilicon region wherein at least a portion of said oxide is permanently located on top of said designated polysilicon region.

4. The method of claim 3 wherein said oxide is developed by oxidizing said designated polysilicon region, and wherein an oxidation inhibiting layer is initially established entirely over at least a layer of polysilicon.

5. The method of claim 1 wherein said barrier material is initially established on top of an area larger than and encompassing said designated resistor region and thereafter defining the resistor by removing selected portions of said barrier material.

6. A method as claimed in any one of the preceding claims, wherein both the polycide line and the polysilicon resistor are simultaneously defined.

7. A method as claimed in claim 6, comprising the steps of locating a photoresist over the silicide and etching the silicide, the barrier material and the polysilicon to define both the polycide line and the polysilicon resistor.

8. The method as claimed in any of claims 1 to 5 wherein selected portions of the barrier material are etched away so as to define a resistor in the designated resistor region after defining a polycide line.

9. A method as claimed in claim 8 comprising the steps of locating a photoresist over the silicide and in a line extending across said designated region but being discontinuous over said designated region, and then etching through the silicide not covered by said photoresist down to said barrier material, and thereafter forming the polysilicon resistor from said designated resistor region.

10. A method of forming a polysilicon resistor in a polycide line comprising the steps of covering a layer of polysilicon in which the resistor and polycide line are to be formed with a layer of oxidation-inhibiting material, etching an opening through said oxidation-inhibiting layer to delineate a designated resistor region, implanting impurities into the polysilicon through said opening, growing a relatively thick oxide in said opening on top of the polysilicon for preventing subsequently added silicide from contacting the polysilicon in the designated resistor region, removing said oxidation-inhibiting layer prior to the step of adding a silicide, adding a layer of silicide covering the polysilicon and said oxide thereon, and defining a polysilicon line through the designated resistor area.

11. A method as claimed in claim 10 wherein said oxidation-inhibiting material is a nitride.

## Patentansprüche

1. Verfahren zur Ausbildung eines Polysilikon-Widerstandes in einer Polycid-Leitung, bei welchem ein Polysilikon-Bereich bestimmt wird, welcher den Widerstand einschließt, das Polysilikon dotiert wird, während der Bereich mit einem Sperrmaterial geschützt wird, eine Silizidschicht darüber gegeben wird und das Silizid abgegrenzt wird, dadurch gekennzeichnet, daß eine Öffnung in einer Schicht über dem Polysilikon erzeugt wird, um den Polysilikon-Bereich freizulegen, wo der Polysilikon-Widerstand angeordnet werden soll, sodann ein Sperrmaterial auf die Oberseite des Polysilikons im wesentlichen innerhalb der Öffnung dauerhaft angebracht wird, sodann eine Silizidschicht auf das Polysilikon und das Sperrmaterial aufgebracht wird, und daß die Schicht und die Sperre so abgegrenzt werden, daß ein Polysilikon-Widerstand im Kontakt mit einer Polycid-Leitung gebildet wird, wobei der Widerstand vom Silizid durch das abgegrenzte Sperrmaterial getrennt ist.

2. Verfahren nach Anspruch 1, bei welchem der bestimmte Polysilikon-Bereich zuerst mit Verunreinigungen für einen Polysilikon-Widerstand dotiert wird und sodann der dotierte Bereich mit dem Sperrmaterial dauerhaft abgedeckt wird.

3. Verfahren nach einem der vorangehenden Ansprüche, bei welchem das Sperrmaterial ein Oxid aufweist, das auf der Oberseite des Polysilikon-Bereiches entwickelt wird, wobei mindestens ein Teil des Oxids auf der Oberseite des bestimmten Polysilikon-Bereiches dauerhaft angebracht wird.

4. Verfahren nach Anspruch 3, bei welchem das Oxid durch Oxydieren des bestimmten Polysilikon-Bereiches entwickelt wird, und bei welchem eine oxidationshindernde Schicht anfänglich vollständig auf wenigstens eine Polysilikon-Schicht aufgebracht wird.

5. Verfahren nach Anspruch 1, bei welchem das Sperrmaterial anfänglich auf die Oberseite eines Bereiches aufgebracht wird, welcher größer ist als der bestimmte Widerstandsbereich und diesen umfaßt, und sodann der Widerstand ausgebildet wird, indem ausgewählte Teile des Sperrmaterials entfernt werden.

6. Verfahren nach einem der vorangehenden Ansprüche, bei welchem sowohl die Polycid-Leitung als auch der Polysilikon-Widerstand gleichzeitig ausgebildet werden.

7. Verfahren nach Anspruch 6, bei welchem ein Photoresist auf das Silizid aufgebracht und das Silizid, das Sperrmaterial und das Polysilikon geätzt werden, um sowohl die Polycid-Leitung als auch den Polysilikon-Widerstand auszubilden.

8. Verfahren nach einem der Ansprüche 1 bis 5, bei welchem ausgewählte Teile des Sperrmaterials weggeätzt werden, um einen Widerstand in dem bestimmten Widerstandsbereich nach Ausbildung einer Policid-Leitung auszubilden.

9. Verfahren nach Anspruch 8, bei welchem ein Photoresist auf dem Silizid und in einer Leitung angebracht wird, die sich quer über den bestimmten Bereich erstreckt, jedoch über dem bestimmten Bereich unterbrochen ist, und sodann durch das nicht vom Photoresist abgedeckte Silizid hindurch bis hinunter zum Sperrmaterial geätzt und sodann der Polysilikon-Widerstand aus dem bestimmten Widerstandsbereich gebildet wird.

10. Verfahren zur Ausbildung eines Polysilikon-Widerstandes in einer Polycid-Leitung, bei welchem eine Polysilikon-Schicht, in der der Widerstand und die Polycid-Leitung ausgebildet werden sollen, mit einer Schicht von oxydationsverhinderndem Material abgedeckt wird, eine Öffnung durch die oxydationsverhindernde Schicht geätzt wird, um einen bestimmten Widerstandsbereich abzugrenzen, Verunreinigungen in das Polysilikon eingebracht werden und daß man sodann ein verhältnismäßig dickes Oxid in der Öffnung auf der Oberseite des Polysilikons anwachsen läßt, um zu verhindern, daß das nachfolgend aufgebrachte Silizid das Polysilikon in dem bestimmten Widerstandsbereich berührt, die oxydationsverhindernde Schicht vor dem Aufbringen eines Silizids entfernt wird, eine das Polysilikon und das darauf befindliche Oxid abdeckende Silizid-Schicht aufgebracht wird und eine Polysilikon-Leitung durch den bestimmten Widerstandsbereich hindurch ausgebildet wird.

11. Verfahren nach Anspruch 10, bei welchem das oxydationsverhindernde Material ein Nitrid ist.

**Revendications**

1. Procédé pour former une résistance en polysilicium dans une ligne du type polycide, qui consiste à désigner une région de polysilicium destinée à contenir la résistance, à doper le polysilicium tout en protégeant ladite région avec une matière constituant une barrière, à superposer une couche de siliciure et à délimiter le siliciure, caractérisé en ce qu'une ouverture est établie dans une couche par-dessus le polysilicium pour exposer la région du polysilicium où la résistance en polysilicium doit être située, puis à mettre en place de façon permanente une matière servant de barrière par-dessus ledit polysilicium principalement dans ladite ouverture, à ajouter ensuite une couche de siliciure par-dessus le polysilicium et la matière servant de barrière, et à délimiter ladite couche et ladite barrière de manière à former une résistance en polysilicium au contact d'une ligne du type polycide, la résistance étant séparée du siliciure par la barrière délimitée.

2. Procédé suivant la revendication 1, dans lequel la région désignée de polysilicium est tout d'abord dopée avec des impuretés pour une résistance en polysilicium, après quoi la région dopée est recouverte de façon permanente de ladite matière servant de barrière.

3. Procédé suivant l'une quelconque des revendications précédentes, dans lequel la matière servant de barrière comprend un oxyde développé par-dessus la région désignée de polysilicium dans laquelle une portion au moins dudit oxyde est disposée de façon permanente par-dessus ladite région désignée de polysilicium.

4. Procédé suivant la revendication 3, dans lequel l'oxyde est développé par oxydation de la région désignée de polysilicium, et une couche inhibitrice d'oxydation est initialement établie entièrement par-dessus au moins une couche de polysilicium.

5. Procédé suivant la revendication 1, dans lequel la matière servant de barrière est initialement établie sur une étendue plus grande que la région désignée pour la résistance et englobant cette région, après quoi la résistance est délimitée par enlèvement de portions choisies de ladite matière servant de barrière.

6. Procédé suivant l'une quelconque des revendications précédentes, dans lequel la ligne du type polycide et la résistance en polysilicium sont délimitées simultanément.

7. Procédé suivant la revendication 6, qui comprend les étapes de localisation d'une photoréserve sur le siliciure et d'attaque chimique du siliciure, de la matière servant de barrière et du polysilicium pour délimiter la ligne du type polycide et la résistance en polysilicium.

8. Procédé suivant l'une quelconque des revendications 1 à 5, dans lequel des portions choisies de la matière servant de barrière sont enlevées par attaque chimique de manière à délimiter une résistance dans la région désignée pour la résistance, après délimitation d'une ligne du type polycide.

9. Procédé suivant la revendication 8, qui comprend les étapes consistant en la localisation d'une photoréserve sur le siliciure et dans une ligne s'étendent en travers de la région désignée, mais étant discontinue sur cette région désignée, en l'attaque chimique à travers le siliciure non recouvert par ladite photoréserve jusqu'à la matière servant de barrière, puis en la formation de la résistance en polysilicium à partir de ladite région désignée pour la résistance.

10. Procédé de formation d'une résistance en polysilicium dans une ligne du type polycide, qui comprend les étapes consistant à recouvrir une couche de polysilicium, dans laquelle la résistance et la ligne du type polycide doivent être formées, d'une couche de matière inhibitrice d'oxydation, à pratiquer par attaque chimique une ouverture dans ladite couche inhibitrice d'oxydation pour délimiter une région destinée à la resistance, à implanter des impuretés dans le polysilicium à travers ladite ouverture, à faire croître un oxyde relativement épais dans ladite ouverture par-dessus le polysilicium pour empêcher le siliciure ajouté par la suite d'entrer en contact avec le polysilicium dans la région destinée à la résistance, à retirer ladite couche inhibitrice d'oxydation avant l'étape d'addition d'un siliciure, à ajouter une couche de siliciure recouvrant le polysilicium et l'oxyde qu'il porte et à délimiter une ligne de polysilicium au travers de la surface destinée à la résistance.

11. Procédé suivant la revendication 10, dans lequel la matière inhibitrice d'oxydation est un nitrure.

18 OXIDE
20 NITRIDE
16 POLY
14 OXIDE
12 SUBSTRATE

*FIG. 1*

*FIG. 2*

*FIG. 3*

26
28
20
18
16
14
12
30
P.R.
NITRIDE
OXIDE
POLY

*FIG. 4*

20
18
16
14
32
OXIDE
NITRIDE
POLY
OXIDE
34  30

FIG.5

FIG.6

FIG.7

FIG.8

FIG.9

FIG.10

FIG. 11

FIG. 12

FIG. 13

*FIG.14*

*FIG.15*

*FIG.16*

*FIG.17*

*FIG.18*